# EUROPEAN PATENT APPLICATION

(11) **EP 1 638 211 A1**
(43) Date of publication of application: **22.03.2006**
(21) Application number: 04292225.2
(22) Date of filing: 16.09.2004
(51) Int. Cl.: H04B 1/10, H03G 3/34, H04N 5/213

(54) **Impulse noise correction**

(71) Applicant: Dibcom, 91120 Palaiseau (FR)
(72) Inventor: Hamman, Emmanuel, 91120 Palaiseau (FR)
(74) Representative: Habasque, Etienne J. Jean-François

(57) **Abstract**

A method of detecting an impulse noise component for a data transmission signal in a mobile environment includes receiving over a communication channel a demodulated signal having an input signal level subject to a fading condition where the input signal level varies without the presence of the impulse noise component; estimating a variation of the input signal level independently of the impulse noise component under the fading condition to obtain a robust signal level estimate of the signal; and detecting the impulse noise component based on the robust signal level estimate and the input signal level. The method also includes reducing the impulse noise component by cancelling a signal component of the received signal whose impulse noise component has been detected.

## Description

### TECHNICAL FIELD

The present invention relates to impulse noise correction.

### BACKGROUND

OFDM or COFDM is a multicarrier modulation technology where the available transmission channel bandwidth is subdivided into a number of discrete channels or carriers that are overlapping and orthogonal to each other. Data are transmitted in the form of symbols that have a predetermined duration and encompass some number of carrier frequencies. The data transmitted over these OFDM symbol carriers may be encoded and modulated in amplitude and/or phase, using conventional schemes.

In a mobile environment, a received signal undergoes signal degradation where the transmission channel is subject to a variety of fading conditions of the received signal such as fast and slow fading. Fast fading refers to changes in signal strength due to direct and reflected signals (multipath) interfering with each other, and slow fading refers to changes in signal strength due to distance and terrain effects. In particular, fast fading signal strength changes are due to relative motion and local scattering objects such as buildings, foliage, and change rapidly over short distances. Slow fading is the change in the local mean signal strength as larger distances are covered. In a highly random environment, fast fading will have a Gaussian distribution while slow fading will tend toward a log normal distribution.

When dealing with fast fading conditions that are encountered in many communication scenarios in a mobile environment, a variation in the order of half a wavelength of the signal carrier is involved. In other words, 50 cm for a FR signal at 600 MHz. This results, in fact, from the superposition of constructive and destructive multipaths between a transmitter and a receiver. Thus, existing receivers use Automatic Gain Control (AGC) to counteract the substantial degradations in performance under fast fading conditions. AGC systems adapt the gain of the signal at the input of the receiver that is considered stable and a simple impulse noise detector can detect the impulse noise. In other words, AGC systems attempt to keep the receiver outputs constant in amplitude over most of the range and to set receiver gain to be inversely proportional to the input level.

A well-known concern in the art of OFDM data transmission systems is that of impulse noise, which can produce bursts of error on transmission channels. Impulse noise or burst interference occurs at unexpected times, lasts for a short period of time (e.g., several microseconds), and corrupts all tones or bands.

To correct the effect of impulse noise, prior systems use a system that detects signals samples with high level with respect to a constant signal level. Therefore, it requires that the AGC loop compensates exactly for all types of fading, including fast fading.

In particular, when the speed of the mobile receiver increases or varies, AGC systems cannot alone effectively compensate for fast fading channel conditions. In fact, without an appropriate system in place to correct noise bound signals subject to fast fading conditions, the channel may suffer substantial degradation in performance due to errors in channel state estimations and impulse noise.

Therefore, it is desirable to develop a new method to correct impulse noise components and improve the quality of the received signals under fading conditions.

### SUMMARY

Accordingly, it is an object of the invention to provide an improved method and system for impulse noise correction.

With the following and other objects in view, the invention features detecting an impulse noise component of a data transmission signal in a mobile environment. The method, as described above, comprises the steps of:
- receiving over a communication channel a demodulated signal having an input signal level subject to a fading condition where the input signal level varies without the presence of the impulse noise component;
- estimating a variation of the input signal level independently of the impulse noise component under the fading condition to obtain a robust signal level estimate of the signal; and
- detecting the impulse noise component based on the robust signal level estimate and the input signal level.

The method also provides for reducing the impulse noise component by cancelling a signal component of the received signal whose impulse noise component has been detected, as recited in claim 2.

In the above, the method deals more efficiently with fast fading conditions and also estimates the input signal level over a time interval (I) having a length adapted to provide accurate estimation of the variation of the signal level and a constant level of the signal. Therefore, the impulse noise correction significantly improves the quality of received signals.

Furthermore, the method features as defined in claim 5 improve the detection of the impulse noise component.

In addition, the invention concerns a communication system to detect an impulse noise component for a data transmission signal according to the above method, and other features of the communication system are recited in the dependent claims.

As recited in claim 11, the invention also features an article (e.g., a chip) including a computer-readable storage medium bearing computer-readable program code capable of causing a processor to:
- receive over a communication channel a demodulated signal having an input signal level subject to a fading condition in a mobile environment where the input signal level varies without the presence of the impulse noise component;
- estimate a variation of the input signal level independently of the impulse noise component under the fading condition obtain a robust signal level estimate of the signal; and
- detect the impulse noise component based on the robust signal level estimate and the input signal level.

Other features of the article are further recited in the dependent claims.

These and other aspects of the impulse noise correction method will be apparent from the following description, drawings, and from the claims.

### BRIEF DESCRIPTION OF THE FIGURES

Figure 1 is a schematic diagram of a receiving unit according to the present invention;
Figure 2 is a schematic diagram of a noise detection unit of the receiving unit of Figure 1;
Figure 3 is a flow chart of a method to correct an impulse noise component;
Figure 4 is a schematic diagram of another noise detection unit of the receiving unit of Figure 1.

### DETAILED DESCRIPTION

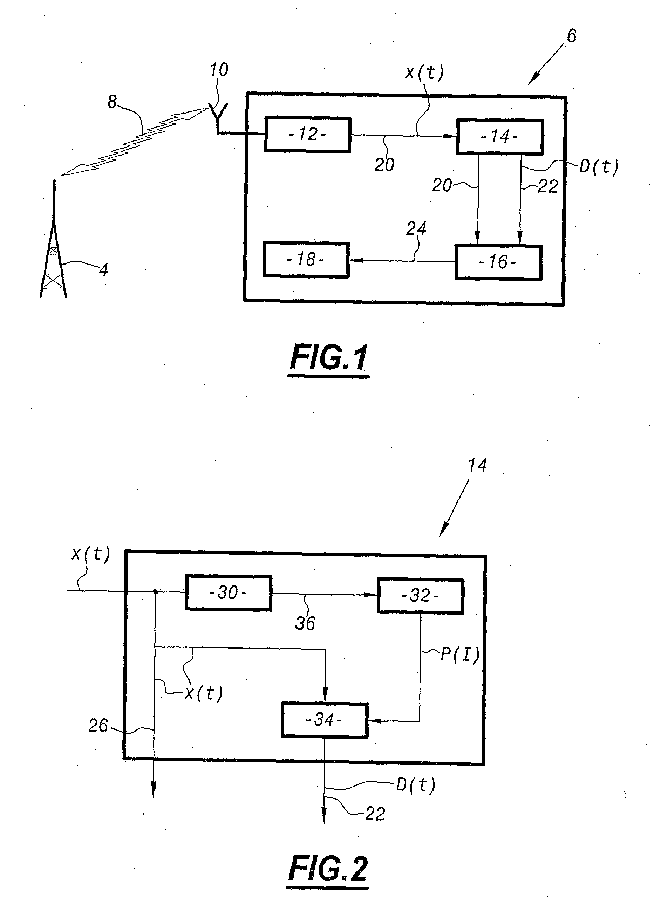

Referring to Figure 1, a communication system 2 includes a transmitter 4 and a receiving unit 6. The transmitter 4 transmits a modulated wave 8 to an antenna 10 associated with the receiving unit 6. The modulated wave 8 is converted by the receiving antenna 10 into a Radio Frequency (RF) signal processed in the receiving unit 6. The receiving unit 6 includes a receiver 12, a noise detection unit 14, a noise reduction unit 16, and a signal processing unit 18.

The modulated wave 8 is directed to the receiving unit 6 where it is initially processed by the receiver 12. The receiver 12 may include conventional signal processing systems such as a tuner, an amplifier, and the like. The modulated wave 8 is also A-D converted in the receiver 12. The receiver 12 outputs a pre-processed signal 20, defined as x(t), that is subsequently subject to further processing in the noise detection unit 14. The noise detection unit 14 carries out the detection of the impulse noises by obtaining a meaningful impulse noise value as distinguished from the signal values. This mechanism is described in greater detail in Figure 2. In the noise detection unit 14, the impulse noises are detected from the pre-processed signal 20 x(t), which outputs in addition to the pre-processed signal 20, a noise reduction control signal 22. These signals are, in turn input into a noise reduction unit 16, which reduces or eliminates the impulse noise component from the pre-processed signal 20 x(t). This is achieved by cancelling a signal component of the received signal whose impulse noise component has been detected, thus outputting a noise free signal 24. The noise free signal 24 is then sent onto the signal processing unit 18 for higher level signal processing.

Referring now to Figure 2, the noise detection unit 14 receives the pre-processed signal 20 x(t) from the receiver 12. The noise detection unit 14 includes a signal sampling unit 30, a robust level estimate circuit 32, and a noise detection circuit 34. After the pre-processed signal 20 x(t) is sampled by the signal sampling unit 30, a sampled signal 36 is input onto the robust level estimate circuit 32.

In particular, the robust level estimate circuit 32 is a circuit adapted to withstand insensitivity against deviations, i.e., conditions departing from an assumed distribution or model outside of normal specifications. Thus, the robust level estimate circuit 32 estimates a variation of the level of the sampled signal 36, for example, in small time intervals (I) referred to as x(t). In this case, if we represent the sampled signal 36, P(I) represents the square root of the mean of the level of the sample signal 36, namely |x(t)|². Furthermore, the length of the interval (I) is sufficiently large to have the most accurate estimation, but sufficiently small to also ensure that the level of |x(t)|² remains constant over the time interval (I). In the robust level estimate circuit 32, the calculation for the estimation must be robust against the impulse noise component of the signal 20 x(t). This means that the estimate must not be significantly affected when sampled signals, x(t), are corrupted by impulse noise component. Different techniques may be applied to make the estimation robust, such as removing high values over a given threshold from the computation of the estimate or to make a simple rough estimate of the impulse noise position and to remove these points from the computation of the sampled signal 36.

Therefore, the robust level estimate circuit 32 produces an estimate of the variation of the pre-processed signal 20 level independently from the impulse noise component under a fast fading condition. This results in a robust signal level estimate for the signal 20 x(t), namely P(I). Thereafter, the noise detection circuit 34 detects the impulse noise component based on the robust signal level estimate P(I) and the signal 20 x(t), and outputs the noise reduction control signal 22 defined as D(t) that is sent to the noise reduction unit 16 for further processing. Moreover, as noted, the signal 20 x(t) is also output directly to the noise reduction unit 16 as shown in a line 26, so that the impulse noise component can be cancelled and the noise free signal 24 can be processed

The framework of the detection algorithm used in connection with Figure 1 and 2 above includes defining a detection function D(t) as the probability of an impulse noise component in the signal 20 x(t) at a time t. The detection function D(t) may be determined by comparing the signal 20 x(t) to a threshold value such that if the signal 20 x(t) is greater or lesser than a given threshold A, for instance, then the detection function D(t) will indicate that the signal energy of the signal 20 x(t) is considered to have the presence of an impulse noise component. In other words, if |x(t)| > A, then D(t) = 1, and if otherwise, D(t) = 0.

Referring back to Figure 2, if the robust signal level estimate P(I) generated by the robust level estimate circuit 32 is now taken in account to determine the noise reduction control signal 22, then the above described algorithm is further refined and adapted. If the |x(t)| > A - P(I), i.e., the adapted threshold, then the detection function D(t) = 1, and if |x(t)| is otherwise, D(t) = 0. This can also be written as D(t) = 1 if |x(t)| / P(I) > A and if otherwise, D(t) = 0. As a result, |x(t)| is normalized using P(I).

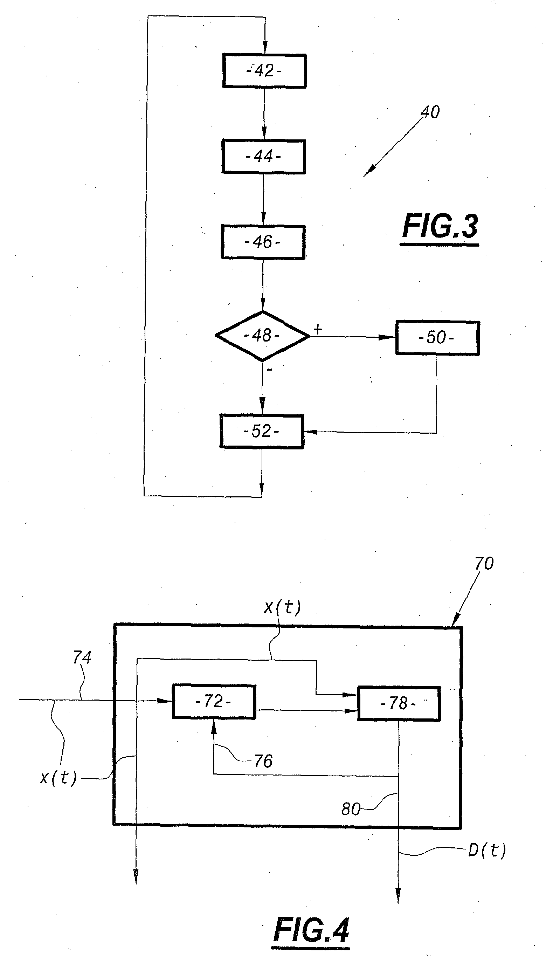

Referring now to Figure 3, a method 40 for correcting impulse noise is illustrated. In the method 40, a signal time interval is used to estimate the level of the signal during a particular time interval in a step 42. As a result, a level of the signal, x(t) is generated. Next, using the generated signal, x(t) as the input, the robust signal level estimate is calculated in a step 44. The resulting output is the robust level of the signal. This is, in turn, used to detect an impulse noise component in a step 46. Here, the detection algorithm is used a detection function defined as a probability of the presence of impulse noise component in the signal as a function of time. Consequently, the output of the detection step 46 generates an impulse noise detection value.

If the impulse noise detection valued has been detected (step 48), then the impulse noise component is removed in an impulse noise removing step 50. Thereafter, the method 40 continues by inputting a next signal time interval to estimate the level of the signal (step 42). On the other hand, if the impulse noise detection value has not been detected (step 52), then the method 40 directly proceeds to the step 42.

Many additional embodiments are possible. For example, referring to Figure 4, another noise detection unit 70 analogous to the noise detection unit 14 of Figure 2 is shown. In this noise detection unit 70, a noise detection circuit 72 detects the impulse noise component based on the signal 74 x(t) and a threshold value 76 generated by a noise reduction unit 78. The noise reduction unit 78 generates the noise free signal 80, defining an impulse noise component in the signal 74 x(t), namely, D(t). In other words, the threshold value 76 is used to compare the signal 74 x(t) to the noise free signal values generated by the noise reduction unit 78 so that the detection of an impulse noise component can be done more accurately with this feedback mechanism. As a result, the noise detection unit 70 can further refine the detection of impulse noise components of signals in a mobile environment.

In addition, the method and systems described above have been described using a particular detection algorithm, but other detection functions are possible.

## Claims

1. A method of detecting an impulse noise component for a data transmission signal in a mobile environment, **characterized in that** the method comprises:
- receiving (42) over a communication channel a demodulated signal having an input signal level subject to a fading condition, wherein the input signal level varies without the presence of the impulse noise component;
- estimating (44) a variation of the input signal level independently of the impulse noise component under the fading condition to obtain a robust signal level estimate of the signal; and
- detecting (46) the impulse noise component based on the robust signal level estimate and the input signal level.

2. The method according to claim 1, wherein the method further comprises reducing (50) the impulse noise component by cancelling a signal component of the received signal whose impulse noise component has been detected.

3. The method according to any of the preceding claims, wherein the fading condition comprises a fast fading condition.

4. The method according to any of the preceding claims, wherein estimating (44) the variation of the input signal level (x(t)) includes estimating the input signal level (x(t)) over a time interval (I) having a length adapted to provide accurate estimation of the variation of the signal level and a constant level of the signal level.

5. The method according to claim 4, wherein the detecting step (46) of the impulse noise component includes defining a detection algorithm wherein a probability of a presence of the impulse noise component (D(t)) is calculated by using the robust signal level estimate (P(t)) over the time interval (I).

6. A communication system to detect an impulse noise component for a data transmission signal in a mobile environment, the system comprising:
- a receiving module (6) configured to receive over a communication channel a demodulated signal having an input signal level subject to a fading condition in a mobile environment, wherein the input signal level varies without the presence of the impulse noise component, the module including a noise detection unit (14) comprising:
- a robust level estimate circuit (32) configured to estimate a variation of an input signal level on a received demodulated signal independently of the impulse noise component under a fading condition to obtain a robust signal level estimate of the signal; and
- a detection unit circuit (34) configured to detect the impulse noise component based on the robust signal level estimate and the input signal level.

7. The communication system according to claim 6, wherein the system further comprises:
- a reduction unit (16) configured to reduce the impulse noise component by cancelling a signal component of the received signal whose impulse noise component has been detected.

8. The system according to any of the preceding claims 6-7, wherein the fading condition is a fast fading condition.

9. The system according to any of the preceding claims 6-8, wherein the robust level estimate circuit (32) is further configured to estimate the input signal level over a time interval (I) having a length adapted to provide accurate estimation of the variation of the signal level and a constant level of the signal level.

10. The system according to claim 9, wherein the detection unit (34) is further configured to define a detection algorithm wherein a probability of a presence of the impulse noise component (D(t)) is computed by using the robust signal level estimate (P(t)) over the time interval (I).

11. An article comprising a computer program product having a sequence of instructions stored on a computer readable medium that when executed by a processor, cause the processor to:
- receive (42) over a communication channel a demodulated signal having an input signal level subject to a fading condition in a mobile environment, wherein the input signal level varies without the presence of the impulse noise component;
- estimate (44) a variation of the input signal level independently of the impulse noise component under the fading condition obtain a robust signal level estimate of the signal; and
- detect (46) the impulse noise component based on the robust signal level estimate and the input signal level.

12. The article according to claim 11, wherein the sequence of instructions further cause the processor to:
- reduce (50) the impulse noise component by cancelling a signal component of the received signal whose impulse noise component has been detected.

13. The article according to according to any of the preceding claims 11-12, wherein the fading condition is a fast fading condition.
